# EUROPÄISCHE PATENTSCHRIFT

(11) **EP 1 415 332 B1**
(45) Veröffentlichungstag und Bekanntmachung des Hinweises auf die Patenterteilung: **25.01.2012**
(21) Anmeldenummer: 02779254.8
(22) Anmeldetag: 25.07.2002
(51) Int. Cl.: H01L 21/20, H01L 21/205, C23C 16/32, C23C 16/54

(54) **Verfahren und Vorrichtung zum Herstellen dünner epitaktischer Halbleiterschichten**
Method and device for the production of epitaxial thin semiconductor layers
Procédé et dispositif pour la production de couches minces épitaxiales

(30) Priorität: 27.07.2001 DE 10137441; 06.09.2001 DE 10144431
(43) Veröffentlichungstag der Anmeldung: 06.05.2004
(73) Patentinhaber: IHP GmbH-Innovations for High Performance Microelectronics / Leibniz-Institut für innovative Mikroelektronik, 15236 Frankfurt / Oder (DE)
(72) Erfinder: TILLACK, Bernd, 15234 Frankfurt (DE); WOLANSKY, Dirk, 15234 Frankfurt (DE); RITTER, Georg, 15236 Frankfurt (DE); GRABOLLA, Thomas, 15518 Arensdorf (DE)
(74) Vertreter: Eisenführ, Speiser & Partner
(86) Internationale Anmeldenummer: PCT/EP2002/008296
(87) Internationale Veröffentlichungsnummer: WO 2003/012840

(56) Entgegenhaltungen:
- EP-A- 1 039 512
- WO-A-00/12785
- WO-A-98/26457
- DE-A- 10 033 940
- US-A- 5 303 671
- RITTER G ET AL: "Low temperature Si epitaxy in a vertical LPCVD batch reactor" MATERIALS SCIENCE AND ENGINEERING B, ELSEVIER SEQUOIA, LAUSANNE, CH, Bd. 73, Nr. 1-3, April 2000 (2000-04), Seiten 203-207, XP004192048 ISSN: 0921-5107
- PATENT ABSTRACTS OF JAPAN vol. 1998, no. 12, 31. Oktober 1998 (1998-10-31) & JP 10 199870 A (SONY CORP), 31. Juli 1998 (1998-07-31)
- BOER DE W B ET AL: "LOW-TEMPERATURE CHEMICAL VAPOR DEPOSITION OF EPITAXIAL SI AND SIGE LAYERS AT ATMOSPHERIC PRESSURE" APPLIED PHYSICS LETTERS, AMERICAN INSTITUTE OF PHYSICS. NEW YORK, US, Bd. 58, Nr. 12, 1991, Seiten 1286-1288, XP001090851 ISSN: 0003-6951 in der Anmeldung erwähnt

## Beschreibung

Die Erfindung betrifft ein Verfahren und Vorrichtungen zum Herstellen dünner, vorzugsweise diffusionshemmender epitaktischer Halbleiterschichten.

Epitaktisch abgeschiedene Halbleiterschichten, vorzugsweise aus SiGe oder Si, mit hohen und scharf begrenzten Dotierungen finden bei der Herstellung von Hochfrequenzbauelementen; wie z. B. 1-Heterobipolartransistoren (HBT) und in CMOS-Schaltungen, zunehmend Anwendung. Bei diesen hochdotierten Schichten besteht das Problem der Ausdiffusion während nachfolgender Prozessschritte mit erhöhten Temperaturen innerhalb der technologischen Abläufe und damit der Degradierung der elektronischen Eigenschaften dieser Schichten. Um diese Diffusionsprozesse zu minimieren, müssen die Temperaturen reduziert und zusätzliche diffusionshemmende Materialien eingesetzt werden.

In der WO 98/26457 wird beschrieben, wie durch die Verwendung eines zusätzlichen, elektrisch nicht aktiven Materials, Vorzugsweise eines Elementes der 4. Hauptgruppe, insbesondere Kohlenstoff in einer Konzentration von 10¹⁸ cm⁻³ bis 10²¹ cm⁻³, die Diffusion von Bor in SiGe signifikant unterdrückt wird. Die Herstellung dieser epitaktischen diffusionshemmenden Schichten, vorzugsweise aus SiGeC oder SiC, geschieht mit Molekularstrahlepitaxie- (MBE) und hauptsächlich mit chemischen Gasphasenabscheide (CVD)- Verfahren. Wie in T.I. Kamins, D.J. Meyer, Appl. Phys. Lett., 59, (1991) 178; W.B. de Boer, D.J. Meyer, Appl. Phys. Lett. 58, (1991) 1286 und B.S. Meyerson, Appl. Phys. Lett. 48, (1986) 797 beschrieben, werden in Verbindung mit CVD-Verfahren Single-Wafer- und Ultra-High-Vacuum (UHV)-Batch-Reaktoren eingesetzt. Bei den Single-Wafer-Reaktoren macht sich nachteilig bemerkbar, dass es sich bei diesen Anlagen nicht um Heißwandreaktoren handelt, d.h. in Single-Wafer-Reaktoren werden die Wafer mittels Strahlungs- oder Induktionsheizung sehr schnell erwärmt, wobei weder der Wafer noch der Reaktor in ein thermodynamnisches Gleichgewicht gelangt.

Wegen der notwendigen kleinen Abscheideraten im Fall der Si-, SiC-, Si-Ge- und SiGeC- Niedertemperaturepitaxie ist mit Single-Wafer-Reaktoren nur ein geringer Durchsatz zu erzielen. Für typische HBT-Stapel beträgt der Durchsatz beispielsweise ca. 5 Wafer/Stunde. Das ist für einen industriellen Prozess ökonomisch ungünstig.

Der einzige bisher bekannt gewordene Batchreaktor ist ein UHV-Heißwandreaktor der im Temperaturbereich von 400°C bis 800°C und typischerweise bei 600°C arbeitet. In diesen Heißwandreaktoren werden die Wafer in kleinen Batches im thermodynamischen Gleichgewicht erhitzt, wodurch zwar eine wesentlich bessere Temperaturhomogenität erreichbar ist, jedoch wirkt sich der mit UHV-Verfahren verbundene hohe Aufwand nachteilig auf den Durchsatz aus. So sind alle peripheren Prozesszeiten (z. B. Pump- und Spülsequenzen, Handling der Scheiben usw.) wesentlich länger als beispielsweise bei üblichen Niederdruck (LPCVD)-Anlagen. Der Durchsatz für typische HBT-Stapel liegt daher bei diesem UHV-Batchreaktor im Bereich der Single-Wafer-Reaktoren, d. h. ca. 5 Wafer/Stunde. Außerdem wirkt sich nachteilig aus, dass wegen des UHV-Systems keine sehr hohen Temperaturen (1000°C und höher) angewendet werden können und so z. B. in dem UHV-Batchreaktor Ätz- und Ausheizprozesse nur bei geringen Temperaturen erfolgen können. Der für UHV-Anlagen erreichte und als notwendig dargestellte geringe H₂O/O₂ Restgehalt für die Niedertemperaturepitaxie lässt sich durch geeignete Maßnahmen auch für nicht UHV-Anlagen erreichen.

Niederdruck(LP)-Batch-Reaktoren fanden bisher keine Anwendung für die Erzeugung diffusionshemmender Halbleiterschichten, insbesondere nicht aus SiGeC oder SiC. Die Ursache dafür ist einerseits die Tatsache, dass der, von der Fachwelt für die Niedertemperaturepitaxie erforderliche geringe Sauerstoff- und Feuchtigkeitsgehalt in diesen Anlagen als nicht realisierbar eingeschätzt wurde. Andererseits treten bei der Hochtemperaturepitaxie in den Batch-Reaktoren Verarmungseffekte in der Gasphase auf, die zu ungenügender Homogenität der abgeschiedenen Schichten auf den Substraten führen. Deshalb haben sich für die Hochtemperaturepitaxie (T ≥ 1000°C) Single-Wafer-Reaktoren durchgesetzt. Bei niedrigen Temperaturen dominieren jedoch kinetische Effekte und transportbedingte Verarmung ist von untergeordneter Bedeutung im Vergleich zum Einfluss der Temperaturhomogenität auf die Schichthomogenität.

WO 0012785 offenbart ein Abscheidungverfahren in einem einzelnen Niederdruckt-Batch-Reaktor.

Aufgabe der Erfindung ist es, ein Verfahren und Vorrichtungen vorzuschlagen, mit Hilfe derer dünne und insbesondere dünne diffusionshemmende epitaktische Halbleiterschichten auf großen in der Halbleitertechnik üblichen Halbleitersubstraten bei einem hohen, für die industrielle Fertigung geeigneten Durchsatz für typische HBT-Stapel herstellbar sind. Verfahren und Vorrichtungen sollen darüber hinaus die notwendigen technologischen Bedingungen, wie eine homogene Temperaturverteilung bei einer geeigneten Betriebstemperatur sowie den notwendig niedrigen Restgehalt an Sauerstoff und Feuchtigkeit gewährleisten.

Erfindungsgemäß wird diese Aufgabe durch das Verfahren des Anspruchs 1 gelöst. Zuerst werden die zu beschichtenden Oberflächen der Halbleitersubstrate durch an sich bekannte Prozeduren nasschemisch und/oder in der Gasphase gereinigt. Dazu eignet sich beispielsweise eine Piranha/SC1/SC2/HF-dip/DI-Rins-Prozedur, eine Piranha/SC1/SC2-Prozedur und/oder eine HF-Vapor-Clean-Prozedur.

Anschließend werden die gereinigten Halbleitersubstrate in einem Niederdruck-Batch-Reaktor auf eine erste, gegenüber dem nachfolgenden Verfahrensschritt höhere Temperatur (Prebake-Temperatur) erwärmt und die zu beschichtenden Oberflächen zur Beseitigung von Luftoxid und anderen Verunreinigungen einem Wasserstoff-Prebake bei einem, gegenüber dem nachfolgenden Verfahrensschritt, gleichen oder höheren Reaktordruck unterzogen.

Im nachfolgenden Verfahrensschritt werden die derart vorbehandelten Halbleitersubstrate in einem Niederdruck-Heiß- oder Warmwand-Batch-Reaktor auf eine zweite, gegenüber dem vorangegangenen Verfahrensschritt niedrigere Temperatur (Abscheidtemperatur) erwärmt und nach Erreichen des thermodynamischen Gleichgewichts auf die zu beschichtenden Oberflächen in einem chemischen Gasabscheideverfahren (CVD) bei einem, gegenüber dem vorangegangenen Verfahrenschritt, gleichen oder geringeren Reaktordruck die dünnen, vorzugsweise diffusionshemmenden Halbleiterschichten abgeschieden. Der CVD-Prozess erfolgt dabei unter solchen Bedingungen, dass die Abscheidung durch Oberflächenreaktionen auf dem Substrat kontrolliert wird und damit Gastransport im Niederdruck-Heiß- oder Warmwand-Batch-Reaktor von untergeordneter Bedeutung ist. Diese Bedingungen sind insbesondere eine geringe Temperatur und/oder ein niedriger Reaktordruck.

Das Wasserstoff-Prebake wird vorzugsweise bei einer Temperatur im Bereich von 750 bis 1100°C und bei einem Gasdruck im Bereich von 0,1 bis 760 Torr und das epitaktische Abscheiden der vorzugsweise diffusionshemmenden Halbleiterschicht vorzugsweise bei einer Temperatur im Bereich von 450 bis 800°C und bei einem Gasdruck im Bereich von 0,1 bis 100 Torr ausgeführt. Besonders bevorzugte Prozessparameter ergeben sich aus den Unteransprüchen.

Es hat sich herausgestellt, dass sich mit Hilfe der angegebenen Verfahrenschritte und insbesondere den angegebenen Verfahrensparametern dünne Schichten ausreichender Homogenität erzielen lassen. Der Erfindung liegt die Erkenntnis zugrunde, dass eine ausreichende Homogenität der Schichten gerade bei dünnen Schichten kritisch ist, wobei die Anforderungen an einen hohen Durchsatz und an eine hohe Homogenität gegenläufig sind. Da die Diffusion von Fremdatomen wie Dotanden in dünne Schichten von relativ größerer Bedeutung ist als bei dickeren Schichten, wird ein Verfahren bevorzugt, bei dem mehrere Schichten erzeugt werden, von denen mindestens eine dünne Schicht diffusionshemmend ausgebildet ist.

Die Verfahrensführung zum Erzeugen der dünnen, diffusionshemmenden Schicht erfolgt vorzugsweise derart, dass ein elektrisch inertes, diffusionshemmendes Element wie Kohlenstoff durch epitaktisches Schichtwachstum im wesentlich substitutionell in die entsprechende Halbleiterschicht eingebracht wird. Die so erzielte Konzentration vorzugsweise substitutionellen Kohlenstoffs ist vorzugsweise kleiner als 1 Atom% bzw. kleiner als 5*10²⁰ cm⁻³. Der besonders bevorzugte Konzentrationsbereich liegt zwischen 1*10²⁰ und 5*10²⁰ cm⁻³.

Zur Herstellung diffusionshemmender epitaktischer Halbleiterschichten, vorzugsweise auf der Basis von SiGeC oder SiC eignet sich als Kohlenstoffquelle beispielsweise Methylsilan.

Durch das erfindungsgemäße Verfahren wird erreicht, dass zum epitaktischen Abscheiden der diffusionshemmenden Halbleiterschichten modifizierte Heißwand-Niederdruck-Batch-Reaktoren zur chemischen Gasphasenabscheidung (LPCVD-Batchreaktoren) eingesetzt werden können, mit Hilfe derer der Durchsatz auf etwa 75 Wafer pro Stunde für typische HBT-Stapel erhöht werden kann. Entscheidend für die Anwendbarkeit der LPCVD-Batchreaktoren für Niedertemperatur Epitaxie ist ein vorhergehender Hochtemperaturprozessschritt in Form eines Wasserstoff-Prebakes, wodurch Luftoxid und andere Verunreinigungen beseitigt werden. In dem nachfolgenden Niedertemperatur-Prozessschritt geschieht das epitaktische Abscheiden der diffusionshemmenden Halbleiterschichten aus der Gasphase. Die erfindungsgemäße Lösung ist dadurch gekennzeichnet, dass dafür zwei gesonderte Batch-Reaktoren verwendet werden, die über eine Transferkammer mit integrierter Inertgasspülung und/oder Vakuumumgebung verbunden sind. Damit ist eine weitere Erhöhung des Durchsatzes ohne die Inkaufnahme technologischer Verluste möglich. Durch das erfindungsgemäße Verfahren werden die nachteiligen Einflüsse vermieden, die infolge eines zu hohen Sauerstoff- und Feuchtigkeitsgehaltes sowie infolge des Auftretens von Verarmungseffekten eintreten können. Darüber hinaus sind auf diese Weise innerhalb der Anlage auch weitere Hochtemperaturbehandlungen wie Reaktorätz- und Ausheizprozesse möglich.

Die für die Durchführung der Verfahren beschriebene Vorrichtung entspricht in ihren Hauptkomponenten, insbesondere dem automatischen Handlingsystem, dem Quarzreaktor in einer widerstandsbeheizten Heizkassette, der Gasversorgung, dem Vakuumsystem usw. modernen LPCVD-Batchreaktoren. Zusätzlich wird ein Transferkammersystem mit integrierter Gasspülung und/oder mit integriertem Vakuumsystem benötigt, dass die Aufrechterhaltung einer Inertgas- bzw. Vakuumumgebung, vorzugsweise (bei der Inertgasspülung) unter Verwendung von Stickstoff mit einem niedrigen Restsauerstoffgehalt (<20 ppm) ermöglicht. Dabei dient das Transferkammersystem in einer Ausführung zum Ein- und Ausbringen der Halbleitersubstrate und in einer anderen Ausführung zusätzlich zur Überführung der Halbleitersubstrate von einem zum anderen Reaktor. Das Handling der Halbleitersubstrate erfolgt somit in inerter Atmosphäre und/oder im Vakuum. Das erste Reaktorsystem ist für die Wasserstoffbehandlungen bei Temperaturen von 750°C bis 1100°C, bei einem Druck von 0,1 bis 760 Torr und bei einem Wasserstofffluss von 1 bis 200 Standardliter pro Minute geeignet. Dazu ist ein in das Hauptsystem integriertes, zweites Reaktorsystem zur Realisierung der Abscheideprozesse vorgesehen. Beide Reaktoren sind über das oben beschriebene Transferkammersystem mit integrierter Inertgasspülung und/oder mit integriertem Vakuumsystem verbunden.

Die Merkmale der Erfindung gehen außer aus den Ansprüchen auch aus der Beschreibung und den Zeichnungen hervor, wobei die einzelnen Merkmale jeweils für sich allein oder zu mehreren in Form von Unterkombinationen schutzfähige Ausführungen darstellen, für die hier Schutz beansprucht wird. Ausführungsbeispiele der Erfindung sind in den Zeichnungen dargestellt und werden im Folgenden näher erläutert. In den zugehörigen Zeichnungen zeigen:
- Fig. 1: eine schematische Darstellung eines herkömmlichen Niederdruck-Batch-Reaktors mit Transferkammer und
- Fig. 2: eine schematische Darstellung zweier Reaktoren, die durch eine Transferkammer verbunden sind.

### Beispiel :

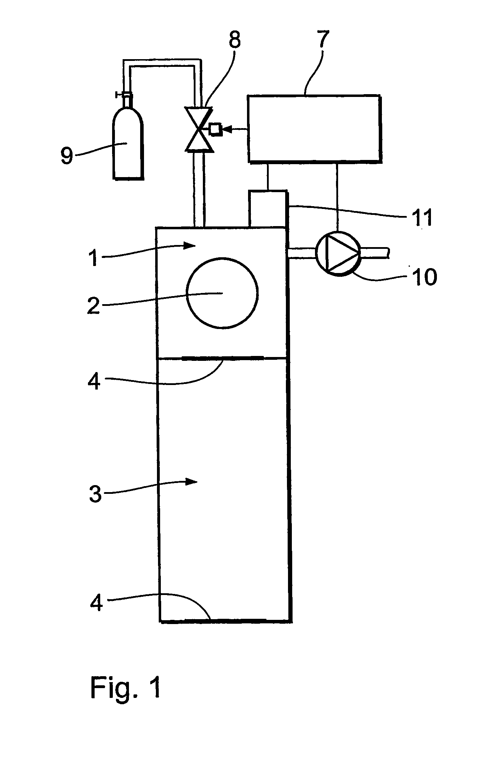

Fig. 1 zeigt einen Niederdruck-Batch-Reaktor zur chemischen Gasphasenabscheidung, für das Abscheiden der dünnen, insbesondere diffusionshemmenden Halbleiterschichten. Die Vorrichtung besteht in diesem Beispiel aus einer Hauptkammer 1, welche einen Niederdruck-Batch-Reaktor 2 beinhaltet, einer an der Hauptkammer 1 angeordneten Transferkammer 3 und einer dazwischenliegenden, dicht schließenden Tür 4 sowie einer weiteren dicht schließenden Tür 4 zur Bestückung der Transferkammer 3. Die Hauptkammer 1 besitzt Vorrichtungen zur Inertgasspülung und/oder zur Herstellung eines Vakuums sowie Vorrichtungen zur Einleitung von Gasen in den Niederdruck-Batch-Reaktor 2; diese Vorrichtungen umfassen eine oder mehrere Gasquellen 9, die über eine steuerbares Ventil 8 mit der Hauptkammer 1 verbunden sind. Außerdem ist eine Vakuumpumpe 10 mit der Hauptkammer 1 verbunden. Zur Steuerung der Inertgasspülung, des Einleitens von Gasen sowie des erzeugens des Vakuums sind die Ventile 8 (von denen nur eines beispielhaft dargestellt ist) und die Vakuumpumpe 10 mit einer Steuuervorrichtung 7 verbunden. Dabei wird ein Niederdruck-Reaktor 2 für das Abscheiden von Halbleiterschichten aus der Gasphase durch konventionelle Vorrichtungen ergänzt, die insbesondere das Durchführen von Hochtemperaturprozessschritten bis 1100°C ermöglichen. In diesem Beispiel ist der Niederdruck-Batch-Reaktor 2 ein Quarzreaktor in einer, insbesondere widerstandsbeheizten Heizkassette. Eine entsprechende Heizung 11 ist ebenfalls mit der Steuervorrichtung 7 verbunden.

Unmittelbar nach der nasschemischen Vorreinigung der Halbleitersubstrate, wofür beispielsweise eine Piranha/SC1/SC2/HF-dip/DI-Prozedur eingesetzt wird, werden die Halbleitersubstrate in die stickstoffgeflutete Transferkammer 3 der LPCVD-Anlage eingebracht. Hier verbleiben diese, bis ein ausreichend niedriger Restgehalt an Sauerstoff und Feuchtigkeit in der Atmosphäre der Transferkammer 3 erreicht ist. Nach der Umlagerung der Substrate aus den Transportbehältern in das Reaktorboot wird dieses in den Niederdruck-Batch-Reaktor 2 eingefahren.

Im Niederdruck-Batch-Reaktor 2 herrscht dabei eine abgesenkte Temperatur auf einem Niveau von z. B. 400°C. Es folgt eine CVD-typische Sequenz von Prozessschritten, die sich hauptsächlich hinsichtlich Temperatur, Druck und Gasatmosphäre unterscheiden.

Nach einer Stabilisierungsphase wird der Niederdruck-Batch-Reaktor 2 hinsichtlich Temperatur und Druck auf Werte gebracht, die den Bedingungen des nunmehr anschließenden Wasserstoff-Prebakes entsprechen (z. B. 850°C und 50 Torr). Das Prebake wird durch das Aufheizen der Wafer auf die entsprechende Prebaketemperatur unter einem Wasserstofffluss zwischen 1 und 200 Standardliter pro Minute, in diesem Beispiel etwa 200 Standardliter pro Minute gestartet.

Nach dem Absenken der Temperatur auf einen zweiten niedrigeren Temperaturwert, beispielsweise 600°C bei 200 mTorr, einschließlich der erforderlichen Stabilisierungszeiten zur Erreichung des thermodynamischen Gleichgewichts, erfolgt das eigentliche Abscheiden der diffusionshemmenden Halbleiterschichten durch das Einleiten der entsprechenden Prozessgase in den Niederdruck-Batch-Reaktor 2. Vorzugsweise wird dazu ein Mischgas aus Wasserstoff und beispielsweise SiH₄ beziehungsweise SiH₂Cl₂ und GeH₄ verwendet. Als Kohlenstoffquelle wird vorzugsweise Methylsilan eingesetzt. Die Halbleiterschichten enthalten in diesem Ausführungsbeispiel SiGe und/oder Si und als diffusionshemmendes Material, das die Diffusion von Dotierstoffen in Si und/oder SiGe signifikant unterdrückt ein elektrisch nicht aktives Element vorzugsweise aus der 4. oder 6. Hauptgruppe, in diesem Ausführungsbeispiel Kohlenstoff. Der Kohlenstoff unterdrückt insbesondere die transient enhanced diffusion (TED) von Bor im SiGe signifikant. Auch Sauerstoff oder eine Kombination von Kohlenstoff und Sauerstoff ist als diffusionshemmendes Material geeignet.

Zwischen dem Abscheiden der einzelnen Schichten können wiederum unterschiedliche prozess-bedingte Temperatur- und Druckwechselvorgänge ablaufen.

Nach dem Abschluss aller Abscheide-Prozesse wird der Niederdruck-Batch-Reaktor 2 freigespült; die Temperatur abgesenkt und der Druck im Niederdruck-Batch-Reaktor 2 und in der Transferkammer 3 angeglichen. Mit dem Ausladen der Substrate ist der Prozess abgeschlossen.

Dieses Verfahren gestattet einen Durchsatz von mehr als 25 Wafer pro Stunde für einen typischen HBT-Stapel.

### Ausführungsbeispiel:

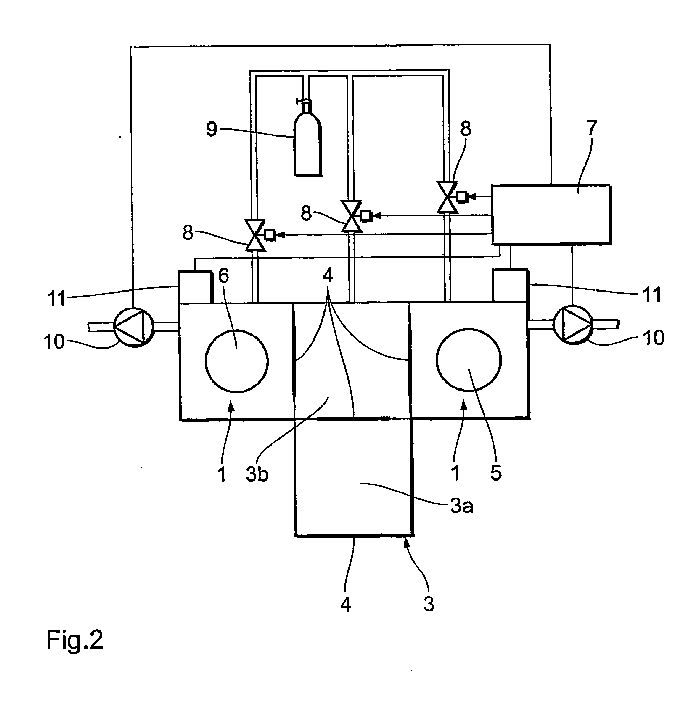

Fig. 2 zeigt ein erfindungsgemäßes Reaktorsystem; bestehend aus zwei Hauptkammern 1 und einer zwischen den Hauptkammern 1 angeordneten Transferkammer 3, wobei die Hauptkammern 1 und die Transferkammer 3 durch dicht schließende Türen 4 verbunden sind und die Transferkammer 3 durch eine derartige Tür 4 bestückbar ist. Die Transferkammer 3 weist außerdem eine Eingangsschleuse 3a auf, über die die Transferkammer 3 zu bestücken ist. Ein Transfer zwischen beiden Hauptkammern 1 erfolgt später in einem Transferbereich 3b der Transferkammer 3, der dann durch eine dicht schließende Tür 4 gegenüber der Eingangsschleuse 3a abgedichtet ist. Weiterhin sind ein Niederdruck-Batch-Reaktor 5 und ein Niederdruck-Heiß- oder Warmwand-Batch-Reaktor 6 in unterschiedlichen Hauptkammern 1 angeordnet. Die Hauptkammern 1 besitzen Vorrichtungen zur Inertgasspülung und/oder zur Herstellung eines Vakuums sowie Vorrichtungen zum Einleiten von Gasen in den Niederdruck-Batch-Reaktor 5 und in den Niederdruck-Heiß- oder Warmwand-Batch-Reaktor 6. Diese Vorrichtungen umfassen Gasquellen 9, die über steuerbare Ventile 8 mit der jeweiligen Hauptkammer 1 verbunden sind. Es sind weiterhin jeweils eine Heizung 11 und eine Vakuumpumpe 10 vorgesehen. Die steuerbaren Ventile 8, die Vakuumpumpen 10 und die Heizungen 11 sind jeweils mit Prozesssteuerungen 7 verbunden, die zum Durchführen des hier beschriebenen Verfahrens geeignet ausgebildet sind. Erfindungsgemäß wird der Niederdruck-Batch-Reaktor 5 für das Abscheiden von Halbleiterschichten aus der Gasphase durch konventionelle Vorrichtungen ergänzt, die insbesondere das Durchführen von Hochtemperaturprozessschritten bis 1100°C ermöglichen. In diesem Ausführungsbeispiel sind der Niederdruck-Batch Reaktor 5 und/oder der Niederdruck-Heiß- oder Warmwand-Batch-Reaktor 6 Quarzreaktoren in jeweils einer, insbesondere widerstandsbeheizten Heizkassette.

Das Wasserstoff-Prebake und das epitaktische Abscheiden der diffusionshemmenden Halbleiterschichten wird in diesem Ausführungsbeispiel in gesonderten Reaktoren gemäß Fig. 2 ausgeführt. Dazu werden nach Abschluss des Wasserstoff-Prebakes die Halbleitersubstrate aus dem ersten Niederdruck-Batch-Reaktor 5 über den Transferbereich 3b der Transferkammer 3 mit der integrierten Inertgasspülung in den zweiten Niederdruck-Heiß- oder Warmwand-Batch-Reaktor 6 überführt. Dadurch kann ein erhöhter Durchsatz realisiert werden. An die beiden Batch-Reaktoren 5, 6 werden bei dieser Arbeitsweise geringere technische Anforderungen gestellt. Entsprechend dem geschilderten erfindungsgemäßen Verfahren sind auch in diesem Fall die erforderlichen Zeiten zur Stabilisierung der umgebenden Atmosphäre in der Transferkammer 3 und im zweiten Niederdruck-Heiß- oder Warmwand-Batch-Reaktor 6 einzuhalten. Weiterhin müssen der Niederdruck-Batch Reaktor 5, der Niederdruck-Heiß- oder Warmwand-Batch-Reaktor 6 und zumindest der Transferbereich 3b der Transferkammer 3 einen geringen Feuchtigkeitspartialdruck aufweisen.

Für den Ausführungsbeispiel ist eine nicht im Detail dargestellte Steuerung 7 vorgesehen, die einen jeweiligen Abscheideprozess beendet, wenn für die jeweilige Halbleiterschicht eine vorgegebene Schichtdicke zwischen 10 und 1000nm erreicht ist. Für das Erzeugen dünner, diffussionshemmender Halbleiterschichten weisen die Reaktoren 2 bzw. 5 außerdem Vorrichtungen 8 und 9 zum Einleiten von Gasen in die Niederdruck-Batch-Reaktoren 2 oder 5 sowie eine damit verbundene Steuervorrichtung 7, die zum Einleiten von Methylsilan in vorgegebener Dosis ausgebildet sind.

Die Steuervorrichtung 7 ist außerdem mit einer Vakuumpumpe 10 zum evakuieren der Reaktoren 2 oder 5 sowie mit einer Heizung 11 zum Erzeugen der erforderlichen Prozesstemperaturen verbunden. Mit Hilfe der Vakuumpumpe 10 und der Vorrichtungen 8 und 9 zum Einleiten von Gasen sind außerdem die gewünschten Prozessdrücke durch die Steuervorrichtung 7 einstellbar. Die Vorrichtungen 8 und 9 zum Einleiten von Gasen können beispielsweise eine oder mehrere Gasflaschen 9 sowie eine entsprechende Anzahl steuerbarer Ventile 8 umfassen.

In der vorliegenden Beschreibung wurden anhand konkreter Ausführungsbeispiele ein Verfahren zur Herstellung diffusionshemmender Halbleiterschichten sowie Vorrichtungen zur Durchführung dieses Verfahrens beschrieben. Es sei aber vermerkt, dass die vorliegende Erfindung nicht auf die Einzelheiten der Beschreibung in den Ausführungsbeispielen beschränkt ist, da im Rahmen der Ansprüche Änderungen und Abwandlungen beansprucht werden.

## Patentansprüche

1. Verfahren zur Herstellung dünner, vorzugsweise diffusionshemmender epitaktischer Halbleiterschichten, vorzugsweise auf der Basis von SiGeC oder SiC, bei dem
a) eine Vielzahl von mehr als 75 Substraten mit einem Durchmesser von wenigstens 150mm zur gleichzeitigen Behandlung in einem Niederdruck-Batch-Reaktor (2, 5) vorgesehen werden,
b) die zu beschichtenden Oberflächen der Vielzahl Halbleitersubstrate nasschemisch und/oder in der Gasphase gereinigt werden,
c) die gereinigten Halbleitersubstrate in dem Niederdruck-Batch-Reaktor (2,5) gemeinsam auf eine erste, gegenüber dem nachfolgenden Verfahrensschritt höhere Temperatur, die Prebake-Temperatur, erwärmt werden und die zu beschichtenden Oberflächen gemeinsam zur Beseitigung von Luftoxid und anderen Verunreinigungen einem Wasserstoff-Prebake bei einem, gegenüber dem nachfolgenden Verfahrensachritt, gleichen oder höheren Reaktordruck unterzogen werden,
d) die derart vorbehandelten Halbleitersubstrate in einem Niederdruck-Heiß- oder Warmwand-Batch-Reaktor (2, 6) gemeinsam auf eine zweite, gegenüber dem vorangegangenen Verfahrensschritt niedrigere Temperatur, die Abscheidetemperatur, erwärmt werden und nach Erreichen des thermodynamischen Gleichgewichts auf die zu beschichtenden Oberflächen in einem chemischen Gasabscheideverfahren bei einem, gegenüber dem vorangegangenen Verfahrensschritt, gleichen oder geringeren Reaktordruck die Halbleiterschichten zugleich epitaktisch abgeschieden werden,
e) wobei das Überführen der Halbleitersubstrate von dem ersten Niederdruck-Batch-Reaktor (5) in den zweiten Niederdruck-Heiß- oder Warmwand-Batch-Reaktor (6) gemeinsam in einer inerten Atmosphäre und/oder im Vakuum geschieht,
f) das chemische Gasabscheideverfahren unter solchen Bedingungen erfolgt, dass die Abscheidung durch Oberflächenreaktionen auf dem Substrat kontrolliert wird und damit Gastransport im, Niederdruck-Heiß- oder Warmwand-Batch-Reaktor (2, 6) von untergeordneter Bedeutung ist, und
g) wobei das Abscheiden einer Halbleiterschicht derart gesteuert wird, dass das Abscheiden einer dünnen epitaktischen Halbleiterschicht endet, wenn die dünne epitaktische Halbleiterschicht eine vorgegebene Dicke zwischen 10 nm und 1000 nm erreicht hat,

2. Verfahren nach Anspruch 1, **dadurch gekennzeichnet, dass** innerhalb eines Gesamtprozesses mehrere Halbleiterschichten aus dem gleichen oder unterschiedlichem Material nacheinander auf den Substraten abgeschieden werden, wobei jede Halbleiterschicht gemäß der Verfahrensschritte aus Anspruch 1 erzeugt wird.

3. Verfahren nach Ansprüchen 1 und 2 **dadurch gekennzeichnet, dass** mindestens eine der hergestellten Halbleiterschichten eine diffusionshemmende Halbleiterschicht ist, die die Diffusion von Fremdatomen in dieser oder anderen Schichten hemmt.

4. Verfahren nach Anspruch 3, **dadurch gekennzeichnet, dass** in die dünne, diffusionshemmende Schicht ein diffusionshemmendes Material, das die Diffusion von Dotierstoffen in Si und/oder SiGe signifikant unterdrückt, eingebracht wird und dass als diffusionshemmendes Material ein Material verwendet wird, dass elektrisch nicht aktiv und vorzugsweise ein Element der 4. oder 6. Hauptgruppe ist.

5. Verfahren nach Anspruch 4, **dadurch gekennzeichnet, dass** das diffusionshemmende Material Kohlenstoff ist.

6. Verfahren nach Anspruch 5, **dadurch gekennzeichnet, dass** der diffusionshemmende Kohlenstoff gemäß Verfahrensschritt d) aus Anspruch 1 aus der Gasphase abgeschieden wird und dass und als Kohlenstoffquelle Methylsilan verwendet wird.

7. Verfahren nach Anspruch 4, **dadurch gekennzeichnet, dass** das diffusionshemmende Material Sauerstoff ist.

8. Verfahren nach einem der Ansprüche 1 bis 7, **dadurch gekennzeichnet, dass** die Bedingungen, unter denen der CVD-Prozess erfolgt, eine geringe Temperatur und/oder ein niedriger Reaktordruck sind.

9. Verfahren nach einem der Ansprüche 3 bis 8, **gekennzeichnet durch** eine Verfahrensführung, die dazu führt, dass das diffusionshemmende Element in der Halbleiterschicht substitutionell in einer Konzentration zwischen 1*10²⁰ und 5*10²⁰ cm⁻³ vorliegt.

10. Verfahren nach einem der Ansprüche 1 bis 9, **dadurch gekennzeichnet, dass** das Wasserstoff-Prebake bei einer Temperatur im Bereich von 750 bis 1100 °C und bei einem Gasdruck im Bereich von 0,1 bis 760 Torr und das epitaktische Abscheiden der diffusionshemmenden Halbleiterschicht bei einer Temperatur im Bereich von 450 bis 800 °C und bei einem Gasdruck im Bereich von 0,1 bis 100 Torr ausgeführt wird.

11. Verfahren nach Anspruch 10, **dadurch gekennzeichnet, dass** das Wasserstoff-Prebake bei einer Temperatur im Bereich von 900 bis 1000 °C, vorzugsweise bei einer Temperatur zwischen 940 und 970 °C ausgeführt wird.

12. Verfahren nach Anspruch 10 oder 11, **dadurch gekennzeichnet, dass** das Wasserstoff-Prebake bei einem Gasdruck im Bereich von 0,5 bis 1 Torr durchgeführt wird.

13. Verfahren nach Anspruch 12, **dadurch gekennzeichnet, dass** das Wasserstoff-Prebake bei einem Gasdruck zwischen 0,8 und 0,9 Torr durchgeführt wird.

14. Verfahren nach einem der Ansprüche 10 bis 13, **dadurch gekennzeichnet, dass** das epitaktische Abscheiden der diffusionshemmenden Halbleiterschicht bei einer Temperatur im Bereich von 600 bis 700 °C und bei einem Gasdruck im Bereich von 0,3 bis 1 Torr ausgeführt wird.

15. Verfahren nach Anspruch 14, **dadurch gekennzeichnet, dass** das epitaktische Abscheiden der diffusionshemmenden Halbleiterschicht bei einer Temperatur im Bereich von zwischen 620 und 670 °C und bei einem Gasdruck im Bereich zwischen 0,45 und 0,85 Torr ausgeführt wird.

16. Verfahren nach einem der Ansprüche 1 bis 15, **dadurch gekennzeichnet, dass** beim CVD-Prozess als Mischgas auf Wasserstoffbasis SiH₄ beziehungsweise SiH₂Cl₂ und GeH₄ eingesetzt wird.

17. Verfahren nach einem der Ansprache 1 bis 16, **dadurch gekennzeichnet, dass** das Wasserstoff-Prebake bei einem Gasdurchfluss von 1 bis 200 Standardliter/Minute ausgeführt wird.

18. Verfahren nach einem der Ansprüche 1 bis 17, **dadurch gekennzeichnet, dass** die nass-chemische Reinigung der zu beschichtenden Oberflächen nach einer Piranha/SC 1 /SC2/HF-dip/DI-Rins-Prozedur und/oder nach einer Piranha/SC1/SC2 - Prozedur ausgeführt wird.

19. Verfahren nach einem der Ansprüche 1 bis 17, **dadurch gekennzeichnet, dass** die nass-chemische Reinigung der zu beschichtenden Oberflächen nach einer HF-Vapor-Clean-Prozedur geschieht.

20. Verfahren nach einem der Ansprüche 1 bis 19, **dadurch gekennzeichnet, dass** die Halbleiterschichten SiGe und/oder Si enthalten.

21. Vorrichtung zur Durchführung des Verfahrens gemäß einem der Ansprüche 1 bis 20, mit
zwei Hauptkammern (1), wobei in einer ersten Hauptkammer ein Niederdruck-Batch-Reaktor (5) und in einer zweiten Hauptkammer ein Niederdruck-Heiß- oder Warmwand-Batch-Reaktor (6) angeordnet sind,
einer zwischen den Hauptkammern (1) angeordneten Transferkammer (3), wobei die Hauptkammern (1) und die Transferkammer (3) durch dicht schließende Türen (4) verbunden sind und die Transferkammer (3) durch eine derartige Tür (4) bestückbar ist und mit einer inerten Atmosphäre und/oder Vakuum beaufschlagbar ist,
wobei die Vorrichtung ausgebildet ist,
im Niederdruck-Batch-Reaktor (2, 5) eine Vielzahl von mehr als 75 Substraten mit einem Durchmesser von wenigstens 150mm zur gleichzeitigen Behandlung aufzunehmen,
die zu beschichtenden Oberflächen der Halbleitersubstrate nasschemisch und/oder in der Gasphase zu reinigen,
die gereinigten Halbleitersubstrate gemeinsam auf eine erste, gegenüber dem nachfolgenden Verfahrensschritt höhere Temperatur, die Prebake-Temperatur, zu erwärmen und die zu beschichtenden Oberflächen gemeinsam zur Beseitigung von Luftoxid und anderen Verunreinigungen einem Wasserstoff-Prebake bei einem gegenüber dem nachfolgenden Verfahrensachritt gleichen oder höheren Reaktordruck zu unterziehen,
die derart vorbehandelten Halbleitersubstrate gemeinsam auf eine zweite, gegenüber dem vorangegangenen Verfahrensschritt niedrigere Temperatur, die Abscheidetemperatur, zu erwärmen und nach Erreichen des thermodynamischen Gleichgewichts auf die zu beschichtenden Oberflächen in einem chemischen Gasabscheideverfahren bei einem, gegenüber dem vorangegangenen Verfahrensschritt, gleichen oder geringeren Reaktordruck die Halbleiterschichten zugleich abzuscheiden, wobei das chemische Gasabscheideverfahren unter solchen Bedingungen erfolgt, dass die Abscheidung durch Oberflächenreaktionen auf dem Substrat kontrolliert wird und damit Gastransport ,von untergeordneter Bedeutung ist,
das Abscheiden einer dünnen epitaktischen Halbleiterschicht derart zu steuern, dass das Abscheiden endet, wenn die dünne epitaktische Halbleiterschicht eine vorgegebene Dicke zwischen 10 nm und 1000 nm erreicht hat,
wobei die Vorrichtung zusätzlich ausgebildet ist, das Wasserstoff-Prebake in dem Niederdruck-Batch-Reaktor (5) für Hochtemperaturprozesse und das epitaktische Abscheiden der dünnen Halbleiterschichten in dem Niederdruck-Heiß- oder Warmwand-Batch-Reaktor (6) für Niedertemperaturprozesse auszuführen, und
die Halbleitersubstrate gemeinsam in einer inerten Atmosphäre und/oder im Vakuum von dem Niederdruck-Batch-Reaktor (5) in den Niederdruck-Heiß- oder Warmwand-Batch-Reaktor (6) zu überführen.

22. Vorrichtung nach Anspruch 21, **dadurch gekennzeichnet, dass** die Hauptkammern (1) Vorrichtungen zur Inertgasspülung und/oder zur Herstellung eines Vakuums sowie Vorrichtungen zur Einleitung von Gasen in den Niederdruck-Batch-Reaktor (5) und in den Niederdruck-Heiß oder Warmwand-Batch-Prebaker (6) besitzen.

23. Vorrichtung nach Anspruch 21 oder 22, **dadurch gekennzeichnet, dass** der Niederdruck-Batch-Reaktor (5) und/oder der Niederdruck-Heiß- oder Warmwand-Batch-Reaktor (6) Quarzreaktoren in jeweils einer, insbesondere widerstandsbeheizten Heizkassette angeordnet ist.

24. Vorrichtung nach Anspruch 22, **dadurch gekennzeichnet, dass** Vorrichtungen zur Einleitung von Gasen einen Anschluss für eine Quelle für Methylsilan in der Gasphase sowie durch eine Steuervorrichtung umfassen, welche derart ausgebildet sind, dass das Erzeugen den dünnen, diffusionshemmenden epitaktischen Halbleiterschicht derart erfolgt, dass die Halbleiterschicht eine Konzentration von Kohlenstoff, zwischen 1*10¹⁸ cm⁻³ und 1*10²¹ cm⁻³ oder zwischen 1*10²⁰ cm⁻³ und 5*10²⁰ cm⁻³ aufweist.

## Claims

1. Process for preparing thin, preferably diffusion-inhibiting epitaxial semiconductor layers, preferably based on SiGeC or SiC, wherein
a) a plurality of more than 75 substrates having a diameter of at least 150 mm are provided for simultaneous treatment in a low pressure batch reactor (2, 5),
b) the surfaces of the plurality of semiconductor substrates that are to be treated are cleaned by a wet chemical method and/or in the gaseous phase,
c) the cleaned semiconductor substrates are heated jointly in the low pressure batch reactor (2, 5) to a first temperature, the pre-bake temperature, that is higher than in the following process step, and the surfaces that are to be treated are jointly subjected to a hydrogen pre-bake at a reactor pressure that is the same as or higher than in the following process step, in order to eliminate airborne oxide and other impurities,
d) the semiconductor substrates thus pre-treated are heated jointly in a low pressure hot or warm wall batch reactor (2, 6) to a second temperature, the deposition temperature, that is lower than in the preceding process step, and after thermodynamic equilibrium has been reached the semiconductor layers are simultaneously precipitated epitaxially onto the surfaces that are to be coated in a chemical gas deposition process at a reactor pressure that is the same as or less than in the preceding process step,
e) the semiconductor substrates being transferred jointly from the first low pressure batch reactor (5) into the second low pressure hot or warm wall batch reactor (6) in an inert atmosphere and/or under vacuum,
f) the chemical gas deposition process taking place under conditions such that the deposition is controlled by surface reactions on the substrate and thus the transporting of gas in the low pressure hot or warm wall batch reactor (2, 6) is of subsidiary importance, and
g) the deposition of a semiconductor layer is controlled so that the deposition of a thin epitaxial semiconductor layer ends when the thin epitaxial semiconductor layer has reached a specified thickness of between 10 nm and 1000 nm.

2. Process according to claim 1, **characterised in that** within an overall process a plurality of semiconductor layers of the same or different materials are deposited successively on the substrates, each semiconductor layer being produced according to the process steps recited in claim 1.

3. Process according to claims 1 and 2, **characterised in that** at least one of the semiconductor layers produced is a diffusion-inhibiting semiconductor layer which inhibits the diffusion of foreign atoms in this or other layers.

4. Process according to claim 3, **characterised in that** a diffusion-inhibiting material that significantly suppresses the diffusion of dopants in Si and/or SiGe is introduced into the thin diffusion-inhibiting layer, and **in that** a material that is electrically inactive and is preferably an element from group IV or group VI is used as the diffusion-inhibiting material.

5. Process according to claim 4, **characterised in that** the diffusion-inhibiting material is carbon.

6. Process according to claim 5, **characterised in that** the diffusion-inhibiting carbon is precipitated from the gaseous phase according to step d) of claim 1 and methylsilane is used as the carbon source.

7. Process according to claim 4, **characterised in that** the diffusion-inhibiting material is oxygen.

8. Process according to one of claims 1 to 7, **characterised in that** the conditions under which the CVD process is carried out are a low temperature and/or a low reactor pressure.

9. Process according to one of claims 3 to 8, **characterised in that** it is conducted so that the diffusion-inhibiting element in the semiconductor layer is substitutionally present in a concentration of between 1 x 10² and 5 x 10²⁰ cm⁻³.

10. Process according to one of claims 1 to 9, **characterised in that** the hydrogen pre-bake is carried out at a temperature in the range from 750 to 1100°C and at a gas pressure in the range from 0.1 to 760 Torr and the epitaxial deposition of the diffusion-inhibiting semiconductor layer is carried out at a temperature in the range from 450 to 800°C and at a gas pressure in the range from 0.1 to 100 Torr.

11. Process according to claim 10, **characterised in that** the hydrogen pre-bake is carried out at a temperature in the range from 900 to 1000°C, preferably at a temperature between 940 and 970°C.

12. Process according to claim 10 or 11, **characterised in that** the hydrogen prebake is carried out at a gas pressure in the range from 0.5 to 1 Torr.

13. Process according to claim 12, **characterised in that** the hydrogen prebake is carried out at a gas pressure of between 0.8 and 0.9 Torr.

14. Process according to one of claims 10 to 13, **characterised in that** the epitaxial deposition of the diffusion-inhibiting semiconductor layer is carried out at a temperature in the range from 600 to 700°C and at a gas pressure in the range from 0.3 to 1 Torr.

15. Process according to claim 14, **characterised in that** the epitaxial deposition of the diffusion-inhibiting semiconductor layer is carried out at a temperature in the range between 620 and 670°C and at a gas pressure in the range between 0.45 and 0.85 Torr.

16. Process according to one of claims 1 to 15, **characterised in that** in the CVD process SiH4 or SiH₂Cl₂ and GeH₄ is used as the hydrogen-based mixed gas.

17. Process according to one of claims 1 to 16, **characterised in that** the hydrogen pre-bake is carried out at a gas throughflow of 1 to 200 standard litres per minute.

18. Process according to one of claims 1 to 17, **characterised in that** the wet-chemical cleaning of the surfaces that are to be coated is carried out using a Piranha/SC1/ SC2/HF-dip/DI-rinse procedure and/or a Piranha/SC1/SC2 procedure.

19. Process according to one of claims 1 to 17, **characterised in that** the wet-chemical cleaning of the surfaces that are to be coated is carried out using an HF Vapour Clean procedure.

20. Process according to one of claims 1 to 19; **characterised in that** the semiconductor layers contain SiGe and/or Si.

21. Apparatus for carrying out the process according to one of claims 1 to 20, having
two main chambers (1), wherein a low pressure batch reactor (5) is provided in a first main chamber and a low pressure hot or warm wall batch reactor (6) is provided in a second main chamber,
a transfer chamber (3) arranged between the main chambers (1), the main chambers (1) and the transfer chamber (3) being connected by tightly closing doors (4) and the transfer chamber (3) being loadable through such a door (4) and being capable of being acted upon by an inert atmosphere and/or vacuum,
the apparatus being configured
to receive a plurality of more than 75 substrates with a diameter of at least 150 mm for simultaneous treatment in the low pressure batch reactor (2, 5),
to dean the surfaces of the semiconductor substrates that are to be coated, by a wet chemical method and/or in the gaseous phase,
to heat the cleaned semiconductor substrates jointly to a first temperature, the pre-bake temperature, that is higher than in the following process step, and jointly to subject the surfaces that are to be coated to a hydrogen pre-bake to eliminate airborne oxide and other impurities, at a reactor pressure that is the same as or higher than in the following process step,
to heat the semiconductor substrates thus pre-treated jointly to a second temperature, the deposition temperature, that is lower than in the previous process step and, after thermodynamic equilibrium has been reached, to deposit the semiconductor layers simultaneously onto the surfaces that are to be coated in a chemical gas deposition process at a reactor pressure that is the same as or less than in the preceding process step, the chemical gas deposition process taking place under conditions such that the deposition is controlled by surface reactions on the substrate and thus the transporting of gas is of subsidiary importance,
to control the deposition of a thin epitaxial semiconductor layer so that the deposition ends when the thin epitaxial semiconductor layer has reached a specified thickness of between 10 nm and 1000 nm,
the apparatus additionally being configured to carry out the hydrogen pre-bake in the low pressure batch reactor (5) for high temperature processes and to carry out the epitaxial deposition of the thin semiconductor layers in the low pressure hot or warm wall batch reactor (6) for low temperature processes, and
to transfer the semiconductor substrates jointly from the first low pressure batch reactor (5) into the low pressure hot or warm wall batch reactor (6) in an inert atmosphere and/or under vacuum.

22. Apparatus according to claim 21, **characterised in that** the main chambers (1) have means for inert gas flushing and/or for producing a vacuum and means for introducing gases into the low pressure batch reactor (5) and into the low pressure hot or warm wall batch pre-baker (6).

23. Apparatus according to claim 21 or 22, **characterised in that** the low pressure batch reactor (5) and/or the low pressure hot or warm wall batch reactor (6) is/are quartz reactors arranged in an, in particular resistor-heated, heating cassette.

24. Apparatus according to claim 22, **characterised in that** means for introducing gases comprise a connection for a source of methylsilane in the gaseous phase and a control device that is configured such that the production of the thin diffusion-inhibiting epitaxial semiconductor layer takes place in such a way that the semiconductor layer has a concentration of carbon of between 1 x 10¹⁸ cm⁻³ and 1 x 10²¹ cm⁻³ or between 1 x 10²⁰ cm⁻³ and 5 x 10²⁰ cm⁻³.

## Revendications

1. Procédé de fabrication de couches de semi-conducteurs minces épitaxiales, de préférence entravant la diffusion, de préférence à base de SiGeC ou SiC, pour lequel :
a) une pluralité de plus de 75 substrats, d'un diamètre d'au moins 150 mm, pour le traitement simultané dans un réacteur en lots à basse pression (2, 5) sont prévus,
b) les surfaces à revêtir de la pluralité de substrats semi-conducteurs sont nettoyées chimiquement par voie humide et/ou en phase gazeuse,
c) les substrats semi-conducteurs nettoyés sont chauffés dans le réacteur en lots à basse pression (2, 5), conjointement, à une première température, plus élevée par rapport à celle de l'étape de procédé subséquente, appelée la température de pré-cuisson, et les surfaces à revêtir sont soumises, conjointement, pour éliminer de l'oxyde imputable à l'action de l'air et d'autres impuretés, à une pré-cuisson sous atmosphère d'hydrogène, conduite à une pression de réacteur identique ou supérieure par rapport à celle de l'étape de procédé subséquente,
d) les substrats semi-conducteurs pré-traités de cette manière sont chauffés dans un réacteur en lots à paroi très chaude ou chaude et basse pression (2, 6), conjointement, à une deuxième température, plus basse que celle de l'étape de procédé précédente, appelée la température de déposition et, après atteinte de l'équilibre thermodynamique, sur les surfaces à revêtir, dans un procédé de déposition chimique en phase gazeuse, à une pression de réacteur identique ou plus faible, par rapport à celle de l'étape de procédé précédente, les couches de semi-conducteur sont en même temps objet d'une déposition épitaxiale,
e) le transfert des substrats semi-conducteurs, du premier réacteur en lots à basse pression (5) dans le deuxième réacteur en lots à paroi très chaude ou chaude et basse pression (6), s'effectue, conjointement, dans une atmosphère inerte et/ou sous vide,
f) le procédé de déposition chimique en phase gazeuse s'effectue dans des conditions telles que la déposition est contrôlée par des réactions en surface s'opérant sur le substrat et, ainsi, le transport de gaz dans le réacteur en lots à paroi très chaude ou chaude et basse pression (2, 6) est d'une importance secondaire, et
g) la déposition d'une couche de semi-conducteur est commandée de manière que la déposition d'une couche de semi-conducteur mince épitaxiale s'achève lorsque la couche de semi-conducteur mince épitaxiale a atteint une épaisseur prédéterminée, entre 10 nm et 1000 nm.

2. Procédé selon la revendication 1, **caractérisé en ce que**, dans le cadre d'un processus global, plusieurs couches de semi-conducteur issues du même matériau ou d'un matériau différent, sont déposées les unes après les autres sur les substrats, chaque couche de semi-conducteur étant générée selon les étapes de procédé issues de la revendication 1.

3. Procédé selon les revendications 1 et 2, **caractérisé en ce qu'**au moins l'une des couches de semi-conducteur produites est une couche de semi-conducteur entravant la diffusion, entravant la diffusion d'atomes étrangers dans cette couche ou dans d'autres couches.

4. Procédé selon la revendication 3, **caractérisé en ce que**, dans la couche mince entravant la diffusion, est introduit un matériau entravant la diffusion, supprimant de manière significative la diffusion de substances dopantes dans Si et/ou SiGe, et **en ce qu'**est utilisé comme matériau entravant la diffusion un matériau qui n'est électriquement pas actif et, de préférence, un élément du 4^{ème} ou 6^{ème} groupe principal.

5. Procédé selon la revendication 4, **caractérisé en ce que** le matériau entravant la diffusion est le carbone.

6. Procédé selon la revendication 5, **caractérisé en ce que** le matériau entravant la diffusion, le carbone selon l'étape de procédé d) de la revendication 1, est déposé à parti de la phase gazeuse et **en ce que** du méthylsilane est utilisé comme source de carbone.

7. Procédé selon la revendication 4, **caractérisé en ce que** le matériau entravant la diffusion est l'oxygène.

8. Procédé selon l'une des revendications 1 à 7, **caractérisé en ce que** les conditions, dans lesquelles s'effectue le processus CVD, sont une faible température et/ou une basse pression de réacteur.

9. Procédé selon l'une des revendications 3 à 7, **caractérisé par** une conduite de procédé menant à ce que l'élément entravant la diffusion dans la couche de semi-conducteur se présente à titre de substitution, en une concentration dans la fourchette comprise entre 1*10²⁰ cm⁻³ et 5*10²⁰ cm⁻³.

10. Procédé selon l'une des revendications 1 à 9, **caractérisé en ce que** la pré-cuisson sous hydrogène est effectuée à une température dans la fourchette comprise entre 750 et 1100°C et à une pression de gaz dans la fourchette comprise entre 0,1 et 760 Torr, et la déposition épitaxiale de la couche de semi-conducteur entravant la diffusion est effectuée à une température dans la fourchette comprise entre 450 et 800°C et pour une pression de gaz dans la fourchette comprise entre 0,1 et 100 Torr.

11. Procédé selon la revendication 10, **caractérisé en ce que** la pré-cuisson sous hydrogène est effectuée à une température dans la fourchette comprise entre 900 et 1000°X, de préférence à une température dans la fourchette comprise entre 940 et 970°C.

12. Procédé selon la revendication 10 ou 11, **caractérisé en ce que** la pré-cuisson sous hydrogène est effectuée à une pression de gaz dans la fourchette comprise entre 0,5 et 1 Torr.

13. Procédé selon la revendication 12, **caractérisé en ce que** la pré-cuisson sous hydrogène est effectuée à une pression de gaz dans la fourchette comprise entre 0,8 et 0,9 Torr.

14. Procédé selon l'une des revendications 10 à 13, **caractérisé en ce que** la déposition épitaxiale de la couche de semi-conducteur entravant la diffusion est effectuée à une température dans la fourchette comprise entre 600 et 700°C et à une pression de gaz dans la fourchette comprise entre 0,3 et 1 Torr.

15. Procédé selon la revendication 14, **caractérisé en ce que** la déposition épitaxiale de la couche de semi-conducteur entravant la diffusion est effectuée à une température dans la fourchette comprise entre 620 et 670°C et à une pression de gaz dans la fourchette comprise entre 0,45 et 0,85 Torr.

16. Procédé selon l'une des revendications 1 à 15, **caractérisé en ce que**, concernant le processus CVD, un utilise comme gaz de mélange à base d'hydrogène SiH₄, respectivement SiH₂Cl₂ et GeH₄.

17. Procédé selon l'une des revendications 1 à 16, **caractérisé en ce que** la pré-cuisson sous hydrogène est effectuée à un flux de gaz dans la fourchette de 1 à 200 litres standard/minute.

18. Procédé selon l'une des revendications 1 à 17, **caractérisé en ce que** le nettoyage chimique par voie humide des surfaces à revêtir est effectué selon une procédure Piranha/SC 1/SC2/HF-dip/DI-Rins et/ou selon une procédure Piranha/SC1/SC2.

19. Procédé selon l'une des revendications 1 à 17, **caractérisé en ce que** le nettoyage chimique par voie humide des surfaces à revêtir est effectué selon une procédure dite HF-Vapor-Clean.

20. Procédé selon l'une des revendications 1 à 19, **caractérisé en ce que** les couches de semi-conducteur contiennent du SiGe et/ou du Si.

21. Dispositif pour la mise en oeuvre du procédé selon l'une des revendications 1 à 20, comprenant :
deux chambres principales (1), un réacteur en lots et basse pression (5) étant disposé dans une première chambre principale et un réacteur en lots à paroi très chaude ou chaude et basse pression (6) étant disposé dans une deuxième chambre principale,
une chambre de transfert (3), disposées entre les chambres principales (1), les chambres principales (1) et la chambre principale (3) étant reliées par des portes (4) fermant de manière étanche, et la chambre de transfert (3) étant susceptible d'être chargée par une porte (4) de ce type et susceptible d'être sollicitée par une atmosphère inerte et/ou un vide,
le dispositif étant réalisé
pour recevoir, dans le réacteur en lots à basse pression (2, 5) un nombre supérieur à 75 substrats, d'un diamètre d'au moins 150 mm, pour un traitement simultané,
pour nettoyer les surfaces à revêtir des substrats semi-conducteurs chimiquement par voie humide et/ou en phase gazeuse,
pour chauffer les substrats semi-conducteurs nettoyés, conjointement, à une première température, plus élevée par rapport à celle de l'étape de procédé subséquente, appelée la température de pré-cuisson, et soumettre les surfaces à revêtir, conjointement, pour éliminer de l'oxyde imputable à l'action de l'air et d'autres ïmpuretés, à une pré-cuisson sous atmosphère d'hydrogène, conduite à une pression de réacteur identique ou supérieure par rapport à celle de l'étape de procédé subséquente,
pour chauffer les substrats semi-conducteurs prétraités de cette manière, conjointement, à une deuxième température, plus basse que celle de l'étape de procédé précédente, appelée la température de déposition et, après atteinte de l'équilibre thermodynamique, sur les surfaces à revêtir, dans un procédé de déposition chimique en phase gazeuse, à une pression de réacteur identique ou plus faible, par rapport à celle de l'étape de procédé précédente, conduire en même temps une déposition des couches de semi-conducteur, le procédé de déposition chimique en phase gazeuse s'effectuant dans des conditions telles que la déposition est contrôlée par des réactions en surface s'opérant sur le substrat et que, ainsi, le transport de gaz est d'une importance secondaire, et
pour commander la déposition d'une couche de semi-conducteur, de manière que la déposition s'achève lorsque la couche de semi-conducteur mince épitaxiale a atteint une épaisseur prédéterminée, entre 10 nm et 1000 nm,
le dispositif étant en plus réalisé pour effectuer la pré-cuisson sous hydrogène dans le réacteur en lots et basse pression (5) pour des processus à haute température et effectuer la déposition épitaxiale des couches de semi-conducteur minces dans le réacteur en lots à paroi très chaude ou chaude et basse pression (6), pour des processus à basse température, et
pour transférer les substrats semi-conducteurs, conjointement, dans une atmosphère inerte et/ou sous vide, du réacteur en lots et basse pression (5) dans le réacteur en lots à paroi très chaude ou chaude et basse pression (6).

22. Dispositif selon la revendication 21, **caractérisé en ce que** les chambres principales (1) comprennent des dispositifs pour le rinçage par gaz inerte et/ou pour établir un vide, ainsi que des dispositifs pour introduire des gaz dans le réacteur en lots et basse pression (5) et dans le pré-cuiseur en lots à paroi très chaude ou chaude et basse pression (6).

23. Dispositif selon la revendication 21 ou 22, **caractérisé en ce que** le réacteur en lots et basse pression (5) et/ou le réacteur en lots à paroi très chaude ou chaude à basse pression (6) est/sont des réacteurs en quartz, dans chacun desquels est disposée une cassette chauffante, en particulier chauffée par résistance électrique.

24. Dispositif selon la revendication 22, **caractérisé en ce que** des dispositifs pour introduire des gaz comprennent un raccordement pour une source pour du méthylsilane dans la phase gazeuse, ainsi qu'un dispositif de commande, réalisés de manière que la génération de couches de semi-conducteurs minces épitaxiales, entravant la diffusion, s'effectue de manière sur la couche de semi-conducteur présente une concentration en carbone, entre 1*10¹⁸ cm⁻³ et 1*10²¹ cm⁻³ ou entre 1*10²⁰ cm⁻³ et 5*10²⁰ cm⁻³.
